# EUROPÄISCHE PATENTSCHRIFT

(11) **EP 0 869 453 B1**
(45) Veröffentlichungstag und Bekanntmachung des Hinweises auf die Patenterteilung: **31.05.2006**
(21) Anmeldenummer: 98103913.4
(22) Anmeldetag: 05.03.1998
(51) Int. Cl.: G06K 19/077

(54) **Verfahren zur Herstellung einer Chipkarte**
Chip card manufacturing process
Procédé de fabrication de carte à puce

(30) Priorität: 13.03.1997 DE 19710144
(43) Veröffentlichungstag der Anmeldung: 07.10.1998
(73) Patentinhaber: Sagem Orga GmbH, 33104 Paderborn (DE)
(72) Erfinder: Fischer, Dirk, Dr., 33106 Paderborn (DE); Fannasch, Lothar, 33647 Bielefeld (DE)

(56) Entgegenhaltungen:
- EP-A- 0 682 321
- DE-A- 19 500 925
- DE-C- 19 505 245

## Beschreibung

Die Erfindung bezieht sich auf ein Verfahren zur Herstellung einer Chipkarte gemäß dem Oberbegriff von Patentanspruch 1.

Chipkarten werden in Form von Telefonkarten, Zugangsberechtigungskarten für Mobilfunktelefone, Bankkarten etc. bereits in großem Umfang eingesetzt. Bei diesen Karten erfolgt die Energieversorgung und der Datenaustausch der Karte mit externen Geräten über den Berührungskontakt (galvanisch) zwischen auf der Karte angeordneten metallischen Kontaktflächen und korrespondierenden Kontakten in den entsprechenden Geräten.

Neben diesen kontaktbehaftet arbeitenden Karten gibt es immer häufiger auch sogenannte kontaktlose Karten, bei denen die Energieversorgung und der Datenaustausch des integrierten Schaltkreises der Karte über eine in der Karte eingebettete Spule (induktiv) erfolgt.

Die Erfindung bezieht sich auf ein Vefahren zur Herstellung von kontaktlosen Chipkarten. Allerdings ist es ohne Einschränkung auch für die Herstellung einer Kombinationschipkarte (kontaktlos und kontaktbehaftet) einsetzbar.

### Stand der Technik:

Bei der Herstellung von kontaktlosen Chipkarten muß die Spule in den Kartenkörper eingebettet werden.

In der DE 195 00 925 A gegen die die Ansprüche abgegrenzt wurden, wird eine Chipkarte beschrieben, bei der ein separates Übertragungsmodul, welches ein induktives und/oder kapazitives Bauteil aufweist, in den Kartenkörper einer Chipkarte eingebaut wird. Das Chipmodul wird zuletzt in den Kartenkörper eingesetzt und mit den induktiven und/oder kapazitiven Bauteilen elektrisch leitend verbunden.

Bei der Herstellung von laminierten, kontaktlosen Chipkarten wird die Spule, die mit ihren Spulenanschlüssen auf einer Spulenträgerschicht angeordnet ist, zwischen der Spulenträgerschicht und einer oder mehreren darüberliegenden Kartenschichten einlaminiert.

Die Spule (Leiterbahnen und Spulenanschlüsse/großflächig ausgeführte Spulenenden) wird vorzugsweise aus einer elektrisch leitend (vorzugsweise mit Kupfer) beschichteten Kunststoffolie geätzt. Dabei ist diese Kunststoffolie bereits die Spulenträgerschicht, oder aber die Kunststoffolie mit der geätzten Spule wird mit einer weiteren Kunststoffschicht zur Ausbildung der Spulenträgerschicht verbunden. In alternativen Ausführungen wird eine drahtgewickelte Spule auf die Spulenträgerschicht aufgeklebt oder teilweise durch Utraschall in diese zur Fixierung hineingepreßt. In einer weiteren Ausführungsform wird die Spule als elektrisch leitende Schicht im Siebdruckverfahren auf die Spulenträgerschicht aufgebracht. Weiterhin ist es auch möglich, die Spule in Form einer elektrisch leitenden Schicht im Heißprägeverfahren auf die Spulenträgerschicht aufzubringen.

Unabhängig von der Ausführungsform der Spule und der Art der Aufbringung auf die Spulenträgerschicht wird in die fertig laminierte Karte eine Aussparung zur Aufnahme eines die integrierte Schaltung (Halbleiterbaustein/Chip) enthaltenden Chipmoduls, das metallische Kontakte zur Verbindung des Chips mit den Spulenanschlüssen aufweist, eingefräst. Dabei werden die Spulenailschlüsse freigelegt, so daß die elektrisch leitende Verbindung zu den entsprechenden Kontakten des Chipmoduls durch einen Leitkleber oder durch ein Lot hergestellt werden kann.

Hierbei gibt es allerdings schwerwiegende Nachteile. Beim Fräsen der Aussparung werden nicht nur die Spulenanschlüsse freigelegt, sondern auch die zwischen den Spulenanschlüssen verlaufenden Spulenwicklungen/Leiterbahnen - weist die Spule N Wicklungen auf, so verlaufen N-1 Wicklungen zwischen den Spulenanschlüssen. Dies führt zu den folgenden Problemen:
a) Die auf der Höhe der Spulenanschlüsse liegenden Leiterbahnen der Spule, die eine Breite von nur ca. 80 µm haben, werden beim Fräsen sehr leicht beschädigt oder vollständig durchtrennt, wodurch die Güte der Spule abnimmt oder diese gar vollständig zerstört wird. Bei den großflächig ausgeführten Spulenanschlüssen (> 1mm²) ist dies nicht so kritisch, da hier ein "Kratzer" nichts ausmacht.
b) Beim Herstellen einer elektrisch leitenden Verbindung zwischen den Kontakten des Chipmoduls und den Spulenanschlüssen durch einen Leitkleber oder durch ein Lot wird sehr leicht, da der Abstand zwischen den Leiterbahnen und der Abstand der Leiterbahn(en) zu den Spulenanschlüssen sehr klein ist, durch den Leitkleber oder das Lot ein elektrischer Kurzschluß zwischen den Leiterbahnen der Spule bzw. zwischen den Leiterbahnen und den Spulenanschlüssen erzeugt, wodurch die Spule unbrauchbar wird. Die Anordnung der Spule (Leiterbahnen und Spulenanschlüsse) auf der Spulenträgerschicht dahingehend zu ändern, daß die Abstände der zwischen den Spulenanschlüssen im Bereich der Aussparung verlaufenden Leiterbahn(en) zu den Spulenanschlüssen größer ist, um einen Kurzschluß zu vermeiden, ist in den meisten Fällen nicht möglich, da auch die Spulenträgerschicht in einem mittleren Bereich zwischen den Spulenanschlüssen zur Aufnahme von Teilen des Chipmoduls aufgefräst wird, wobei dort verlaufende Leiterbahnen zerstört würden. Zur Vermeidung von Kurzschlüssen zu und zwischen den Leiterbahen müßte in aufwendiger Weise ein Lötstoplack eingesetzt werden, oder aber die Leiterbahnen müßten (bei der Herstellung der Spule oder nach dem Fräsen der Aussparung) in ebenso aufwendiger wie kostenintensiver Weise mit einer isolierenden Beschichtung versehen werden. Allerdings besteht auch hier wieder das Problem, das die Beschichtungen und die Leiterbahnen selbst beim Fräsen zerstört werden.

Vor diesem Hintergrund ist es die Aufgabe der Erfindung, ein Verfahren zur Herstellung von kontaktlosen Chipkarten der oben genannten Art zu entwickeln, das die zuverlässige Herstellung von kontaktlosen Chipkarten bei minimalem Ausschuß gewährleistet und darüber hinaus kostengünstig ist.

Diese Aufgabe wird durch die kennzeichnenden Merkmale des Patentanspruches 1 gelöst. Die sich daran anschließenden Unteransprüche enthalten vorteilhafte und förderliche Ausgestaltungen des Verfahrens.

Ein erfindungsgemäßes Verfahren zur Herstellung einer Chipkarte, die im Wesentlichen aus einem mehrschichtigen Kunststoff-Kartenkörper, einem in einem Chipmodul angeordneten integrierten Schaltkreis, mindestens einer Spule, die der Energieversorgung und/oder dem Datenaustausch des integrierten Schaltkreises mit externen Geräten dient, wobei das Chipmodul wenigstens zwei metallische Kontakte zur elektrisch leitenden Verbindung des integrierten Schaltkreises mit den Anschlüssen der auf einer Spulenträgerschicht angeordneten Spule aufweist, besteht aus folgenden Schritten:
- Bereitstellung aller Schichten, die die fertige Chipkarte bilden (Spulenträgerschicht mit der darauf angeordneten Spule und den Spulenanschlüssen, einer auf die Spulenträgerschicht spulenanschlußseitig aufzubringenden Abdeckschicht, wobei die Abdeckschicht zu den Spulenanschlüssen korrespondierende Aussparungen aufweist, mindestens einer auf der Abdeckschicht aufzubringenden Dickenausgleich-Schicht),
- positionsgenaues Übereinanderlegen dieser Kartenschichten, wobei die Abdeckschicht so positioniert wird, daß die Aussparungen in der Abdeckschicht jeweils im Bereich der Spulenanschlüsse liegen,
- Einbringen der übereinandergelegten Kartenschichten in eine Laminationspresse, wo die Kartenschichten unter Druck und Wärme miteinander verbunden werden, wobei von der Spulenträgerschicht unter Anhebung der Spulenanschlüsse Kunststoffmasse in die Aussparungen der Abdeckschicht hineingepreßt wird, Entnahme der laminierten Kartenschichten aus der Laminationspresse,
- Taschenfräsen einer Aussparung zur Aufnahme des Chipmoduls in den laminierten Kartenkörper, wobei die angehobenen Spulenanschlüsse freigelegt werden,
- Einsetzen des Chipmoduls in die Aussparung des Kartenkörpers und Herstellung der elektrisch leitenden Verbindung zwischen den Kontakten des Chipmoduls und den Spulenanschlüssen.

Bei einer besonders vorteilhaften Ausführung des erfindungsmäßigen Verfahrens wird zusätzlich zu den genannten Schichten mindestens eine Dickenausgleich-Schicht, die auf der den Spulenanschlüssen abgewandten Seite der Spulenträgerschicht aufzubringen ist, bereitgestellt und dann dem weiteren genannten, erfinderischem Verfahren ausgesetzt.

Durch das Bereitstellen und Einlaminieren der Abdeckschicht mit den Aussparungen wird beim Taschenfräsen vermieden, dass die Spulenwicklungen beschädigt werden, da bei der Lamination unter Anhebung der Spulenanschlüsse Kunststoffmasse in die Aussparungen der Abdeckschicht hineingepreßt wird und somit die Spulenanschlüsse gegenüber der übrigen Spulenträgerschicht und den Leiterbahnen der Spule höckerartig angehoben sind. Bei der Herstellung der leitenden Verbindungen zwischen den Kontakten des Chipmoduls und den Spulenanschlüssen kann es nicht zu einem Kurzschluß zwischen den Leiterbahnen bzw. zwischen den Leiterbahnen und den Spulenanschlüssen kommen, da anschlußseitig nur noch die Spulenanschlüsse zugänglich sind, da der Rest der Spule durch die Abdeckschicht abgedeckt ist.

Auf den beigefügten Zeichnungen soll das erfindungsgemäße Verfahren näher erläutert und die Vorteile aufgezeigt werden. Es zeigt:

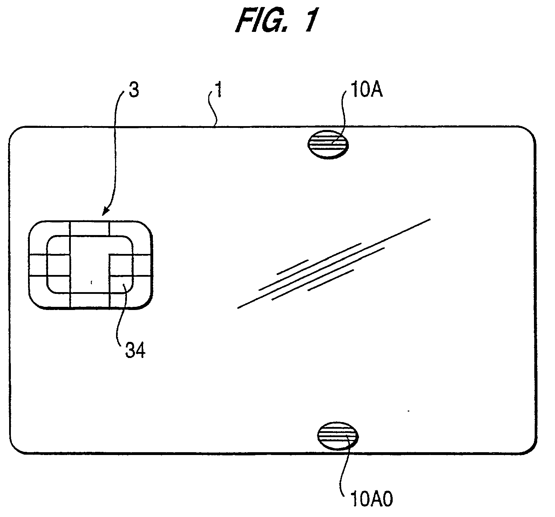

- Fig.1: eine Draufsicht auf eine erfindungsgemäße Chipkarte, wobei die Oberfläche an zwei Stellen zur Sichtbarmachung der Spulenleiterbahnen aufgebrochen dargestellt ist,
- Fig.2: eine Draufsicht auf die Spulenträgerschicht,
- Fig.3: eine Draufsicht auf die Abdeckschicht mit den zu den Spulenanschlüssen korrespondierenden Aussparungen,
- Fig.4: die verschiedenen Kartenschichten vor dem Laminieren,

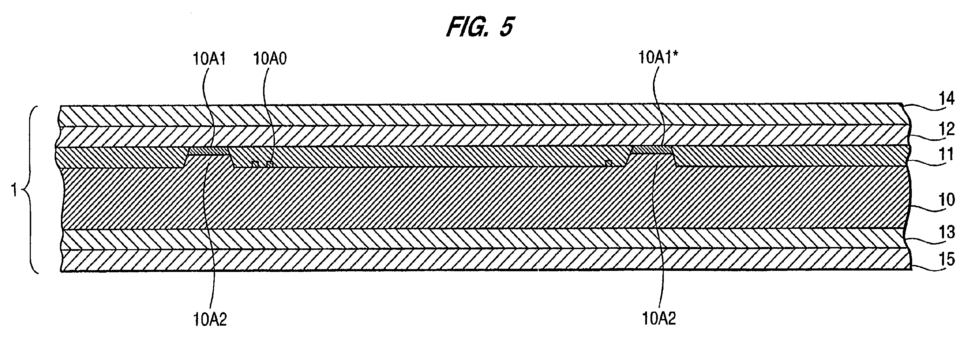

- Fig. 5: einen Schnitt durch die fertig laminierte Karte,
- Fig.6: einen Schnitt durch eine Karte mit eingefräster Aussparung sowie einen Schnitt durch das einzusetzende Chipmodul,
- Fig.7 bis Fig.9: jeweils einen Schnitt durch eine Karte mit eingefräster Aussparung, jedoch unterschiedlichen Arten der Aufbringung des leitfähigen Klebers zur Verbindung der Spulenanschlüsse mit den Kontakten des Chipmoduls,

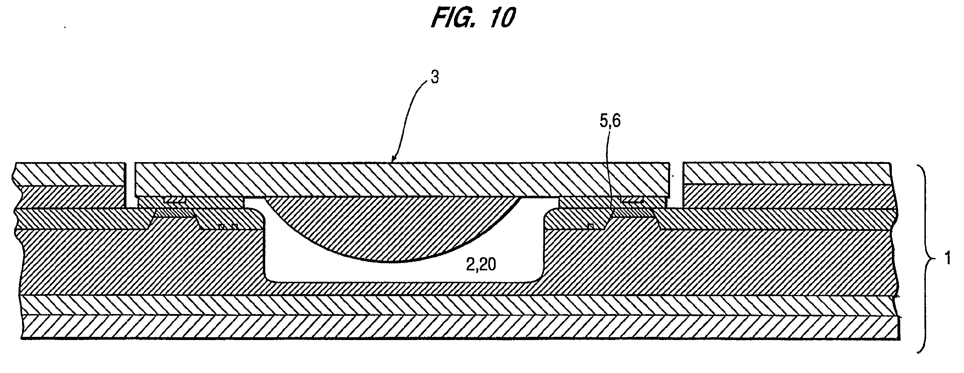

- Fig.10: einen Schnitt durch eine fertige Karte mit implantiertem Chipmodul,
- Fig.11: einen Schnitt durch das Chipmodul, der mehr Detailinformationen zeigt.

Die Erfindung beschreibt ein Verfahren zur Herstellung einer Chipkarte bestehend aus einem mehrschichtigen Kunststoff Kartenkörper (1), einem in einem Chipmodul (3) angeordneten integrieten Schaltkreis (Halbleiterbaustein/Chip,31) und mindestens einer Spule (10A), die der Energieversorgung und/oder dem Datenaustausch des integrierten Schaltkreises (31) mit externen Geräten dient. Dabei weist das Chipmodul (3) wenigstens zwei metallische Kontakte (32,32*) zur elektrisch leitenden Verbindung des integrierten Schaltkreises (31) mit den Anschlüssen (10A1,10A1*) der auf einer Spulenträgerschicht (10) angeordneten Spule (10A) auf.

Insbesondere bezieht sich die Erfindung auf ein Verfahren zur Herstellung von Chipkarten gemäß ISO 7810-Format mit einer Kartendicke von (760 ± 8)µm.

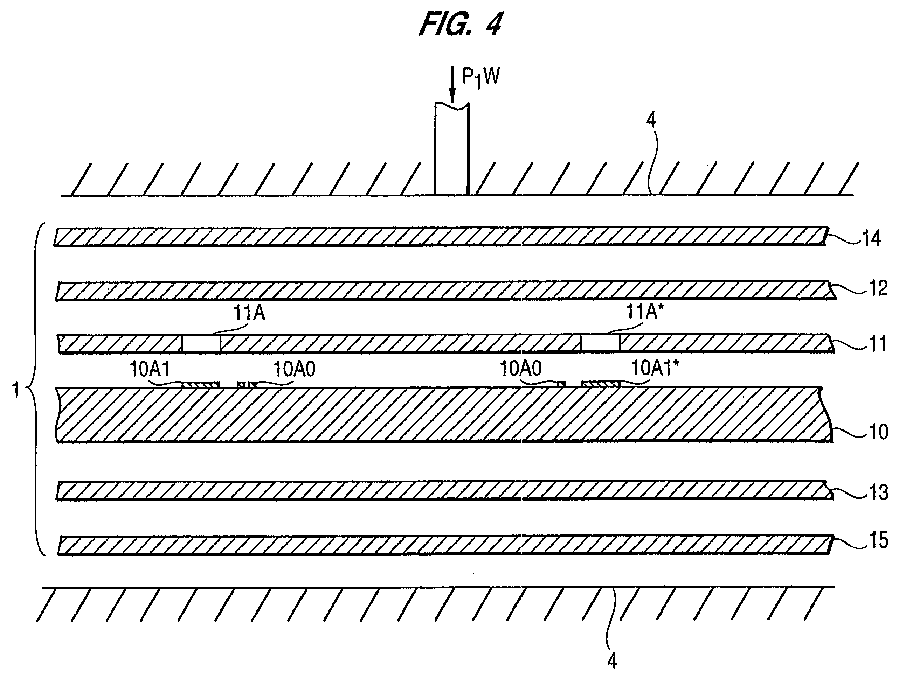

Für die herzustellende Karte werden in dem dargestellten Ausführungsbeispiel 6 Kartenschichten miteinander durch Lamination verbunden - vgl.Fig.4: der Spulenträgerschicht (10) mit der darauf angeordneten Spule (10A) mit ihren Spulenleiterbahnen (10A0) und den Spulenanschlüssen (10A1,10A1*); einer spulenanschlußseitig auf die Spulenträgerschicht (10) aufzubringenden Abdeckschicht (11); einer auf die Abdeckschicht (11) aufzubringenden Dickenausgleich-Schicht (12); einer kartenvorderseitigen Deckschicht (Overlay,14); einer Dickenausgleich-Schicht (13); die auf die den Spulenanschlüssen abgewandten Seite der Spulenträgerschicht (10) aufgebracht wird; und einer kartenrückseitigen Deckschicht (15).

Bei den Dickenausgleich-Schichten (12,13) werden bedruckte Kunststoffolien eingesetzt, während für die darüber aufzubringenden Kartendeckschichten (14,15) transparente Overlayfolien verwendet werden.

Allerdings läßt sich das erfindungsgemäße Verfahren auch schon mit drei Kartenschichten, und zwar der Spulenträgerschicht (10), der Abdeckschicht (11) und der darauf befindlichen Dickenausgleich-Schicht (13) durchführen. Zur Erzielung der Normkartendicke werden die Dicken der einzelnen Kartenschichten entsprechend gewählt und aufeinander abgestimmt.

Zur Herstellung des erfindungsgemäß laminierten Kartenkörpers wird in bekannter Weise bevorzugt die sogenannte Mehrfachnutzenfertigung - im Unterschied zur Einzelkartenfertigung - eingesetzt, wodurch der Durchsatz gegenüber der Einzelkartenfertigung sehr viel größer ist. Bei der Mehrfachnutzenfertigung werden für jede Kartenschicht Mehrfachnutzen-Bogen (Spulenträgerschicht-Bogen, Abdeckschicht-Bogen (), Dickenausgleich-Schicht-Bogen etc.) mit jeweils einer Vielzahl von Einzelementen (Spulenträgerschichten, Abdeckschichten, Dickenausgleich-Schichten etc.) zur Herstellung einer Vielzahl von laminierten Kartenkörpem eingesetzt. Nach der Lamination werden die Einzelkartenkörper durch Ausstanzen aus dem Bogen erhalten. Sowohl in der Einzelkartenfertigung als auch in der Mehrfachnutzenfertigung sind die Schichten bzw. Bogen passgenau vor der Lamination übereinander zu legen.

Für das erfindungsgemäße Verfahren macht es keinen Unterschied, ob Einzelkartenfertigung oder Mehrfachnutzenfertigung durchgeführt wird.

Erfindungsgemäß weist die auf die Spulenträgerschicht (10) aufzubringende Abdeckschicht (11) zu den Spulenanschlüssen (10A1,10A1*) korrespondierende Aussparungen (11A,11A*) auf, wobei die Abdeckschicht (11) so über der Spulenträgerschicht (10) positioniert wird, daß die Aussparungen (11A,11A*) jeweils im Bereich der Spulenanschlüsse (10A1, 10A1*) liegen. Bei der Lamination der Schichten (10,11,12,13,14,15) in einer Laminationspresse (4) - vgl. Fig.4 - werden die Kartenschichten unter dem Einfluß von Druck und Wärme miteinander verbunden. Der Vorteil des erfindungsgemäßen Verfahrens ist nun, daß bei der Lamination von der Spulenträgerschicht (10) unter Anhebung der Spulenanschlüsse (10A1,10A1*) Kunststoffmasse in die Aussparungen (11A,11A*) der Abdeckschicht (11) hineingepreßt wird. Die Spulenanschlüsse (10A1,10A1*) sind somit gegenüber der übrigen Spulenträgerschicht (10) und den Leiterbahnen (10A0) der Spule (10A) höckerartig angehoben.

Nach der Entnahme der laminierten Karten aus der Laminationspresse (4) - bei der Mehrfachnutzenfertigung kommt noch der Verfahrensschritt des Ausstanzens der Einzelkarten hinzu - wird in den laminierten Kartenkörper (1) in einer Taschenfräsanlage (nicht dargestellt) eine Aussparung (2) zur Aufnahme des Chipmoduls (3) eingefräst. Dabei werden die angehobenen Spulenanschlüsse (10A1,10A1*) freigelegt, während die tieferliegenden Leiterbahnen (10A0) der Spule (10A) - auch zwischen den Spulenanschlüssen - geschützt und isolierend unter der Abdeckschicht (11) angeordnet sind.

Durch das erfindungsgemäße Anheben der Spulenanschlüsse (11A1,11A1*), die ja zur Kontaktierung des Chipmoduls (3) durch Fräsen freigelegt werden müssen, gegenüber den Spulenleiterbahnen (10A0), wird vermieden, daß die Spulenleiterbahnen (10A0) beim Freifräsen der Spulenanschlüsse (10A1,10A1*) beschädigt oder gar vollständig zerstört werden.

Außerdem wird in vorteilhafter Weise die Gefahr eines Kurzschlusses bei der Herstellung einer elektrisch leitenden Verbindung zwischen den Kontakten (32,32*) des Chipmoduls (3) und den Spulenanschlüssen (10A1,10A1*) durch Leitkleber oder Lot ausgeschlossen, da die Spulenleiterbahnen (10A0) von den Spulenanschlüssen (10A1,10A1*) durch die isolierende Abdeckschicht (11) getrennt sind.

Die einleitend erwähnten Probleme bei der Herstellung von kontaktlosen Chipkarten sind somit durch das erfindungsgemäße Verfahren beseitigt worden. Hier ist ein zuverlässiges Herstellungsverfahren für kontaktlose Chipkarten mit minimalen Ausschuß geschaffen worden.

Um das Anheben der Spulenanschlüsse (10A1,10A1*) zu begünstigen, wird für die Spulenträgerschicht (10) ein Kunststoff-Material mit einer niedrigeren Formbeständigkeit unter dem Einfluß von Druck und Wärme verwendet als für die Abdeckschicht (11) und die darüber angeordnete Dickenausgleich-Schicht (12). Die niedrigere Formbeständigkeit der Spulenträgerschicht (10) drückt sich in einer niedrigeren Vicat-Erweichungstemperatur aus. Dies kann zum Beispiel dadurch bewirkt werden, daß dem Kunststoffmaterial Füllstoffpartikel (z.B. Titandioxid), die die Formbeständigkeit erhöhen beigemengt werden, wobei die Füllstoffkonzentration der Spulenträgerschicht (10) geringer als die der übrigen Schichten (11,12) ist, wodurch eine geringere Formbeständigkeit der Spulenträgerschicht (10) erreicht wird. In einem bevorzugten Ausführungsbeispiel bestehen die Kartenschichten aus thermisch nicht rekristallisierendem Polyester (Polyethylenterephthalt; PETG). Dieses Material ist umweltfreundlich zu recyclen oder zu entsorgen.

Statt der Verwendung eines Kartenmaterials für alle Kartenschichten, jedoch mit weniger Füllstoffpartikeln in der Spulenträgerschicht (10), ist es auch vorgesehen, für die Spulenträgerschicht (10) einen gänzlich anderen Kunststoff als für die Abdeckschicht (11) und die Dickenausgleich-Schicht (12) zu verwenden - z.B. PVC für die Spulenträgerschicht (10) und Polycarbonat für die Abdeckschicht (11) und die Dickenausgleich-Schicht (12). Die Vicat-Erweichungstemperaturen von PVC liegen je nach Art des PVCs ca. zwischen 70°-80°, während die Vicat-Erweichungstemperaturen von PC je nach Art zwischen ca. zwischen 120° und 130° liegen.

Die Dicke der Spulenanschlüsse (10A1,10A1*) sowie der Spulenleiterbahnen (10A0) beträgt zwischen 20-80µm. Die Dicke der Abdeckschicht (11) beträgt zwischen 40-200µm. In jedem Fall ist die Dicke der Spulenanschlüsse kleiner als die Dicke der Abdeckschicht.

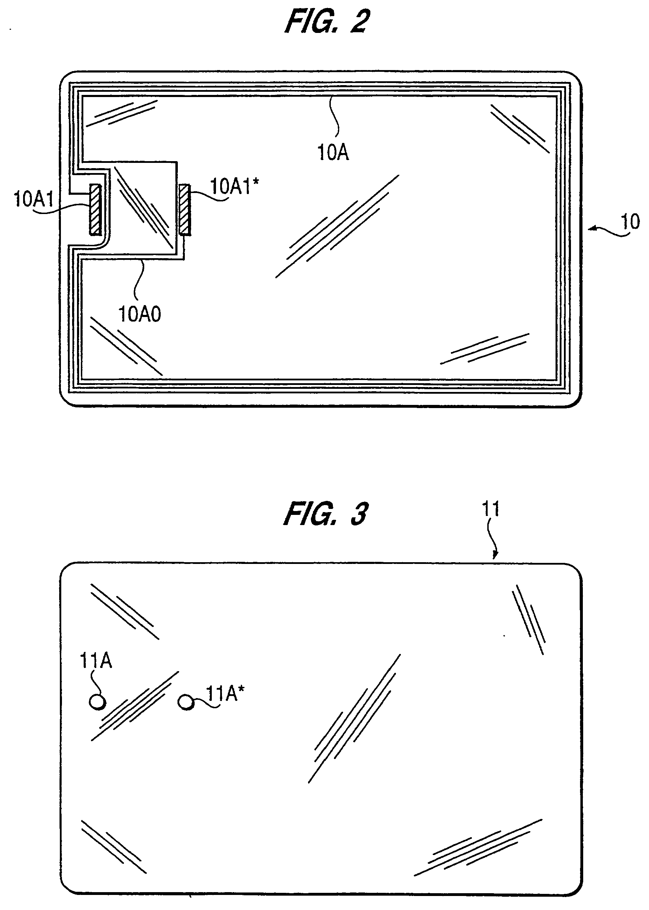

In Fig.2 und Fig.3 ist eine Draufsicht auf die Spulenträgerschicht (10) bzw. auf die Abdeckschicht (11) gezeigt. Die Spulenanschlüsse (10A1,10A1*) in diesem Ausführungsbeispiel sind länglich ausgeführt und haben eine Breite von ca. 1,5mm und eine Länge von ca. 8mm (die Zeichnungen sind nicht maßstabsgetreu). Die Aussparungen (11A,11A*) der Abdeckschicht (11) sind vorzugsweise kreisrund ausgebildet und haben einen Durchmesser, der der Breite der Spulenanschlüsse (10A1,10A1*) in etwa entspricht. Die Abdeckschicht (11) wird mit ihren Aussparungen (11A, 11A*) jeweils mittig zur Breitenerstreckung der Spulenanschlüsse positioniert. Damit wird sichergestellt, daß auch die Leiterbahnen (10A0) zwischen den Spulenanschlüssen (10A1,10A1*) von der Abdeckschicht (11) vollständig verdeckt werden. In dem dargestellten Beispiel sind die Aussparungen der Abdeckschicht auch in Längserstreckung mittig über den Spulenanschlüssen angeordnet. Es ist jedoch auch vorgesehen, Abdeckschichten mit einer anderen Lage der Aussparungen relativ zur Längserstreckung der Spulenanschlüsse zu verwenden, wenn die Anordnung der Lage der Kontakte (32,32*) an dem Chipmodul (3) eine andere Position der erhabenen, freigelegten Spulenanschlüsse (10A1,10A1*) erfordert.

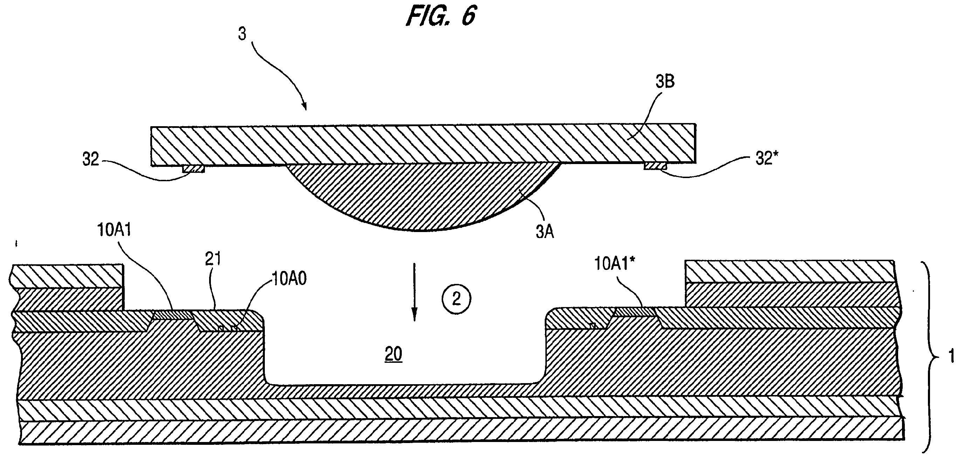

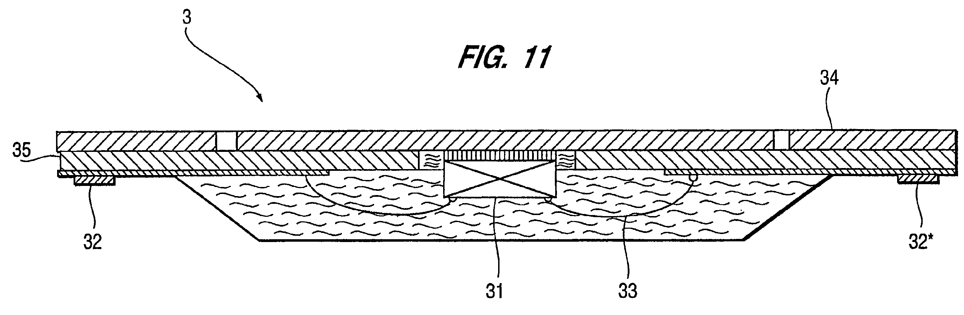

Das für diese Chipkarte verwendete Chipmodul (3) - vgl. Fig.6 und Fig. 11 - besteht aus einem ersten Teil in Form eines Gußgehäuses (3A), das die integrierte Schaltung (31) und die Anschlußleitungen (33) von der integrierten Schaltung (31) zu den metallischen Kontakten (32,32*) zur Verbindung mit den Spulenanschlüssen (10A1,10A1*) aufweist, und aus einem zweiten Teil (3B), das über den Rand des Gußgehäuses (3A) hinausragt und die metallischen Kontakte (32,32*) zur Verbindung mit den Spulenanschlüssen aufweist. In Fig.11 ist dieses Chipmodul (3) etwas detailierter dargestellt. Hierbei handelt es sich um ein Chipmodul (3), das sowohl eine kontaktlose als auch eine kontaktbehaftete Funktion der Karte ermöglicht. Die metallischen Kontaktflächen (34) für die berührende Betriebsweise der Karte befinden sich auf der Oberfläche der Modulträgerschicht (z.B. eine glasfaserverstärkte Epoxydharzschicht, 35). Die Verbindung zwischen diesen Kontaktflächen (34) und dem Chip (31) ist in diesem Schnitt nicht zu erkennen. Die Kontakte (32,32*) zur Verbindung mit den Spulenanschlüssen (10A1,10A1*) befinden sich auf der Rückseite der Modulträgerschicht (35). Sie sind als Leiterbahnen verlängert bis in das Gußgehäuse (3A) hinein ausgeführt, wo sie mit den Anschlußleitungen (Bonddrähte,33) des Chips (31) verbunden sind. Das Gußgehäuse (3A) dient als Schutz für den Chip (31) und die dünnen Anschlußleitungen (33).

Entsprechend der Form des Chipmoduls (3) wird die Aussparung (2) zur Aufnahme des Chipmoduls (3) zweistufig mit einer mittig in der Aussparung (2) liegenden Vertiefung (20) mit einer diese Vertiefung (20) umgebenden Auflageschulter (21) ausgefräst, wobei die freigelegten Spulenanschlüsse (10A1,10A1*) auf den Auflageschultern (21) liegen. Das Chipmodul (3) wird dann zumindest mit seinem über das Gußgehäuse (3A) hinausragendem zweiten Teil (3B) auf der ausgefrästen Auflageschulter (21) liegend mit dem Kartenkörper (1) verbunden, wobei eine elektrisch leitende Verbindung zwischen den Kontakten (32,32*) des Chipmoduls (3) und den Spulenanschlüssen (10A1,10A1*) hergestellt wird.

Bei der Verwendung von sehr flachen Chipmodulen kann auf eine zweistufige Aussparung mit zusätzlicher mittiger Vertiefung verzichtet werden.

Die Kontakte (32,32*) des Chipmoduls (3) können über einen elektrisch leitfähigen Kleber (5), einen Lötprozeß oder durch Schweißen mit den Spulenanschlüssen (10A1,10A1*) elektrisch leitend verbunden werden. Dabei kann die elektrisch leitende Verbindung (z.B. bei der Verwendung spezieller Leitkleber) auch für die mechanische Fixierung des Chipmoduls (3) im Kartenkörper (1) ausreichen. Vorzugsweise wird das Modul jedoch durch zusätzliche Klebeverbindungen in dem Kartenkörper gehalten.

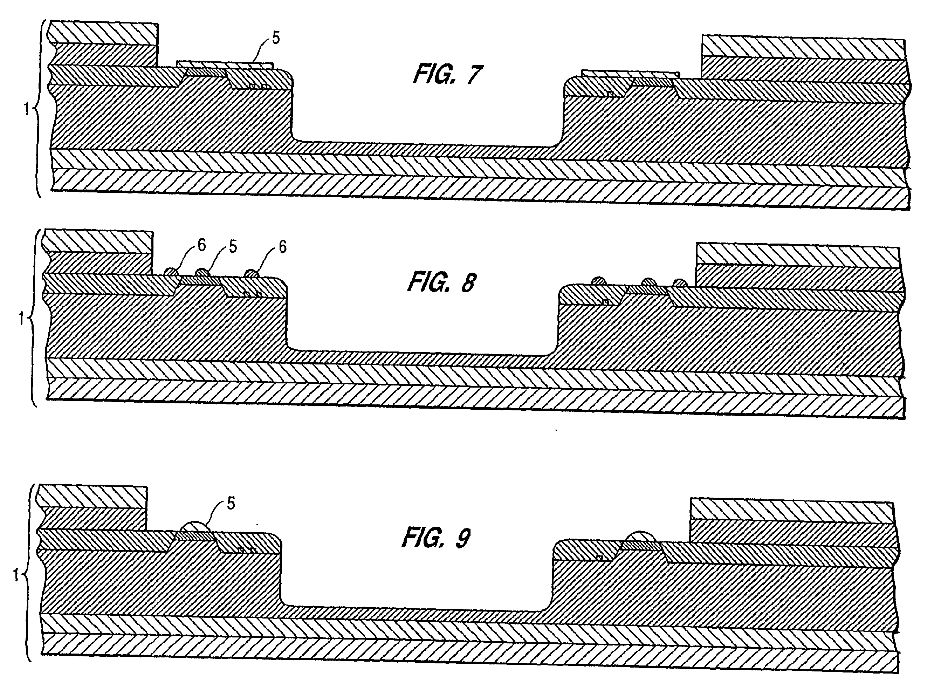

In Fig. 7 bis 8 sind unterschiedliche Arten der Aufbringung eines leitfähigen Klebers (5) dargestellt. In Fig.7 wird der Leitkleber (5) mit einem Dispenser vollflächig über einen Bereich größer als die freigelegten Spulenanschlüsse (10A1,10A1*) aufgebracht. Der Steueraufwand für den Dispenser ist hierbei in vorteilhater Weise gering. Kurzschlüsse können hierbei - wie oben erwähnt - nicht entstehen. In Fig. 8 und 9 wird jeweils nur ein Leitklebertropfen (5) auf die Spulenanschlüsse (10A1,10A1*) aufgebracht. In Fig. 8 sind zusätzlich auf der Auflageschulter (21) der Aussparung (2) noch Tropfen (6) eines nichtleitenden Klebers zur sicheren Fixierung des Chipmoduls (3) im Kartenkörper aufgebracht. Auch die Applizierung eines Heißklebers ist vorgesehen.

## Patentansprüche

1. Verfahren zur Herstellung einer Chipkarte bestehend aus
- einem mehrschichtigen Kunststoff-Kartenkörper (1) ,
- einem in einem Chipmodul (3) angeordneten integrieten Schaltkreis (31),
- mindestens einer Spule (10A), die der Energieversorgung und/oder dem Datenaustausch des integrierten Schaltkreises mit externen Geräten dient, wobei das Chipmodul (3) wenigstens zwei metallische Kontakte (32, 32*) zur elektrisch leitenden Verbindung des integrierten Schaltkreises (31) mit den Anschlüssen der auf einer Spulenträgerschicht (10) angeordneten Spule (10A) aufweist,
wobei das Verfahren die Schritte
- Bereitstellung der Spulenträgerschicht (10) mit der darauf angeordneten Spule (10A) und den Spulenanschlüssen (10A1, 10A1*),
- Bereitstellung weiterer Schichten (14, 15),
- das positionsgenaue Übereinanderlegen dieser Kartenschichten (10, 14, 15),
- Einbringen der übereinandergelegten Kartenschichten in eine Laminationspresse (4), wo die Kartenschichten unter Druck und Wärme miteinander verbunden werden,
- Entnahme der laminierten Kartenschichten aus der Laminationspresse (4),
- Taschenfräsen einer Aussparung (2) zur Aufnahme des Chipmoduls (3) in den laminierten Kartenkörper (1) , wobei die Spulenanschlüsse (10A1, 10A1*) freigelegt werden und
- Einsetzen des Chipmoduls (3) in die Aussparung (2) des Kartenkörpers (1) und Herstellung der elektrisch leitenden Verbindung zwischen den Kontakten (32, 32*) des Chipmoduls (3) und den Spulenanschlüssen (10A1, 10A1*) umfasst
**dadurch gekennzeichnet, dass**
a) zusätzlich eine auf die Spulenträgerschicht (10) spulenanschlußseitig aufzubringende Abdeckschicht (11), und zusätzlich mindestens eine auf die Abdeckschicht (11) aufzubringende Dickenausgleich-Schicht (12) bereitgestellt werden, wobei die Abdeckschicht (11) zu den Spulenanschlüssen (10A1, 10A1*) korrespondierende Aussparungen (11A, 11A*) aufweist,
b) beim positionsgenauen Übereinanderlegen dieser Kartenschichten (10, 11, 12, 14, 15) die Abdeckschicht (11) so positioniert wird, daß die Aussparungen (11A, 11A*) in der Abdeckschicht (11) jeweils im Bereich der Spulenanschlüsse (10A1,10A1*) liegen,
c) während des Laminationsprozesses in der Laminationspresse (4), wo die Kartenschichten unter Druck und Wärme miteinander verbunden werden, von der Spulenträgerschicht (10) unter Anhebung der Spulenanschlüsse (10A1,10A1*) Kunststoffmasse in die Aussparungen (11A, 11A*) der Abdeckschicht (11) hineingepreßt wird,
e) beim Taschenfräsen der Aussparung (2) zur Aufnahme des Chipmoduls (3) in den laminierten Kartenkörper (1) die angehobenen Spulenanschlüsse (10A1,10A1*) freigelegt werden.

2. Verfahren nach Anspruch 1, **dadurch gekennzeichnet, dass** zusätzlich zu den genannten Schichten mindestens eine weitere Dickenausgleichschicht (13) bereitgestellt wird, die auf der den Spulenanschlüssen abgewandten Seite der Spulenträgerschicht aufzubringen ist.

3. Verfahren nach Anspruch 2,
**dadurch gekennzeichnet, daß**
die Dickenausgleich-Schicht (12), die auf der Abdeckschicht (11) angeordnet ist, und die Dickenausgleichschicht (13), die auf der Spulenträgerschicht (10) angeordnet ist, bedruckt sind, und auf den bedruckten Dickenausgleich-Schichten (12,13) jeweils eine weitere transparente Dickenausgleich-Schicht (14,15) als Kartendeckschicht angeordnet ist.

4. Verfahren nach einem der vorstehenden Ansprüche,
**dadurch gekennzeichnet, daß**
das Kunststoff-Material der Spulenträgerschicht (10) eine niedrigere Formbeständigkeit unter dem Einfluß von Druck und Wärme aufweist als die Kunststoff-Materialien der Abdeckschicht (11) und der darüber angeordneten Dickenausgleich-Schicht (12).

5. Verfahren nach Anspruch 4,
**dadurch gekennzeichnet, daß**
die Spulenträgerschicht (10), die Abdeckschicht (11) sowie die Dickenausgleich-Schicht (12) aus dem gleichen Kunststoff bestehen, wobei der Kunststoff Füllstoffpartikel **wie z.B.** Titandioxid aufweist, die die Formbeständigkeit erhöhen, und die Füllstoffkonzentration der Spulenträgerschicht (10) und damit die Formbeständigkeit dieser Schicht (11) geringer als die der anderen Schichten (11,12) ist.

6. Verfahren nach Anspruch 5,
**dadurch gekennzeichnet, daß**
der Kunststoff thermisch nicht rekristallisierendes Polyester **wie z.B**. **Polyethylenterephthalat mit Kurzzeichen PETG** ist.

7. Verfahren nach Anspruch 4,
**dadurch gekennzeichnet, daß**
die Spulenträgerschicht (10) aus PVC und die Abdeckschicht (11) und die Dickenausgleich- Schicht (12) aus Polycarbonat bestehen.

8. Verfahren nach einem der vorstehenden Ansprüche,
**dadurch gekennzeichnet, daß** die Dicke der Spulenanschlüsse (10A1,10A1*) auf der Spulenträgerschicht (10) 20-80µm beträgt

9. Verfahren nach einem der vorstehenden Ansprüche,
**dadurch gekennzeichnet, daß** die Dicke der Abdeckschicht (11) 40-200µm beträgt.

10. Verfahren nach einem der vorstehenden Ansprüche,
**dadurch gekennzeichnet, daß**
die in den Kartenkörper (1) eingefräste Aussparung (2) zur Aufnahme des Chipmoduls (3) zweistufig mit einer mittig in der Aussparung (2) liegenden Vertiefung (20) und einer diese Vertiefung (20) umgebenden Auflageschulter (21) ausgebildet wird, wobei die freigelegten Spulenanschlüsse (10A1,10A1*) auf den Auflageschultern (21) angeordnet sind, und
ein Chipmodul (3) verwendet wird, das aus einem ersten Teil in Form eines Gußgehäuses (3A) besteht, das die integrierte Schaltung (31) und die Anschlußleitungen (33) von der integrierten Schaltung (31) zu den metallischen Kontakten (32,32*) zur Verbindung mit den Spulenanschlüssen (10A1,10A1*) aufweist, und aus einem zweiten Teil (3B) besteht, das über den Rand des Gußgehäuses (3A) hinausragt und die metallischen Kontakte (32,32*) zur Verbindung mit den Spulenanschlüssen (10A1,10A1*) aufweist,
wobei das Chipmodul (3) zumindest mit seinem über das Gußgehäuse (3A) hinausragendem zweiten Teil (3B) auf der ausgefrästen Auflageschulter (21) liegend mit dem Kartenkörper (1) verbunden ist und eine elektrisch leitende Verbindung zwischen den Kontakten (32,32*) des Chipmoduls (3) und den Spulenanschlüssen (10A1,10A1*) hergestellt wird.

11. Verfahren nach einem der vorstehenden Ansprüche,
**dadurch gekennzeichnet, daß** die Kontakte (32,32*) des Chipmoduls (3) mit den Spulenanschlüssen (10A1,10A1*) über einen elektrisch leitfähigen Kleber (5) verbunden sind.

12. Verfahren nach einem der vorstehenden Ansprüche,
**dadurch** gekennzeichent, daß
das Chipmodul (3) über den leitfähigen Kleber (5) in dem Kartenkörper (1) mechanisch fixiert wird.

13. Verfahren nach Anspruch 11,
**dadurch gekennzeichnet, daß** das Chipmodul (3) zusätzlich zu dem leitfähigen Kleber (5) über eine Klebeverbindung (6) in dem Kartenkörper (1) mechanisch fixiert wird.

14. Verfahren nach einem der Ansprüche 1 bis 10,
**dadurch gekennzeichnet, daß**
die Kontakte (32,32*) des Chipmodul (3) über einen Lötprozeß mit den Spulenanschlüssen (10A1,10A1*) elektrisch leitend verbunden werden.

15. Verfahren nach Anspruch 14,
**dadurch gekennzeichnet, daß**
das Chipmodul (3) über die Lötverbindung gleichzeitig in dem Kartenkörper mechanisch fixiert wird.

16. Verfahren nach Anspruch 14,
**dadurch gekennzeichnet, daß**
das Chipmodul (3) zusätzlich zu der Lötverbindung über eine Klebeverbindung in dem Kartenkörper (1) mechanisch fixiert wird.

17. Verfahren nach einem der vorstehenden Ansprüche,
**dadurch gekennzeichnet, daß**
ein Chipmodul (3) verwendet wird, das neben den Kontakten (32,32*) zur elektrisch leitenden Verbindung mit den Spulenanschlüssen (10A1,10A1*) Kontaktflächen (34) aufweist, die auf der den Kontakten (32,32*) gegenüberliegenden Seite des Chipmoduls (3) angeordnet sind, und zur berührenden Energieversorung und/oder Datenaustausch mit externen Geräten dienen.

## Claims

1. Method for manufacturing a smart card comprising
- a multi-layered plastic card body (1),
- an integrated circuit (31) arranged in a chip module (3),
- at least one coil (10A) which serves for the power supply and/or the data exchange of the integrated circuit with external devices, with the chip module (3) having at least two metallic contacts (32, 32*) for the electroconductive connection of the integrated circuit (31) to the terminals of the coil (10A) arranged on a coil carrier layer (10),
wherein the method encompasses the steps of
- providing the coil carrier layer (10) with the coil (10A) and the coil terminals (10A1, 10A1*) arranged thereon,
- providing further layers (14, 15),
- stacking said card layers (10, 14, 15) with precise positional accuracy,
- placing the stacked card layers in a lamination press (4) where the card layers are joined to one other under pressure and heat,
- removing the laminated card layers from the lamination press (4),
- pocket-milling a cavity (2) for accommodating the chip module (3) in the laminated card body (1), whereby the coil terminals (10A1, 10A1*) are exposed, and
- inserting the chip module (3) into the cavity (2) of the card body (1) and producing the electroconductive connection between the contacts (32, 32*) of the chip module (3) and the coil terminals (10A1, 10A1*),
**characterized in that**
a) additionally provided are a covering layer (11) to be applied to the coil carrier layer (10) on the side of the coil terminals and at least one thickness compensation layer (12) to be applied to the covering layer (11), with the covering layer (11) having cavities (11A, 11A*) which correspond to the coil terminals (10A1, 10A1*),
b) when stacking said card layers (10, 11, 12, 14, 15) with precise positional accuracy, the covering layer (11) is positioned in such a way that the cavities (11 A, 11A*) in the covering layer (11) lie in the region of the coil terminals (10A1, 10A1*) in each case,
c) during the lamination process in the lamination press (4) where the card layers are joined under pressure and heat, plastic material is pressed from the coil carrier layer (10) into the cavities (11A, 11A*) of the covering layer (11), with the coil terminals (10A1, 10A1*) being raised,
d) during pocket-milling of the cavity (2) for accommodating the chip module (3) in the laminated card body (1), the raised coil terminals (10A1, 10A1*) are exposed.

2. Method according to Claim 1, **characterized in that**, in addition to the aforesaid layers, at least one further thickness compensation layer (13) is provided, which is to be applied on the side of the coil carrier layer facing away from the coil terminals.

3. Method according to Claim 2,
**characterized in that**
the thickness compensation layer (12) arranged on the covering layer (11) and the thickness compensation layer (13) arranged on the coil carrier layer (10) are printed, and a further transparent thickness compensation layer (14,15) is arranged as a card covering layer on the printed thickness compensation layers (12, 13) in each case.

4. Method according to one of the preceding claims,
**characterized in that**
the plastic material of the coil carrier layer (10) has a lower dimensional stability under the influence of pressure and heat than the plastic materials of the covering layer (11) and of the thickness compensation layer (12) arranged above it.

5. Method according to Claim 4,
**characterized in that**
the coil carrier layer (10), the covering layer (11) and the thickness compensation layer (12) are made of the same plastic, wherein the plastic contains filler material such as titanium dioxide for example which increases the dimensional stability, and the filler concentration of the coil carrier layer (10), and consequently the dimensional stability of said layer (11), is lower than that of the other layers (11, 12).

6. Method according to Claim 5,
**characterized in that**
the plastic is thermally non-recrystallizing polyester such as polyethylene terephthalate, known as PETG for short.

7. Method according to Claim 4,
**characterized in that**
the coil carrier layer (10) is made of PVC and the covering layer (11) and the thickness compensation layer (12) are made of polycarbonate.

8. Method according to one of the preceding claims,
**characterized in that** the thickness of the coil terminals (10A1, 10A1*) on the coil carrier layer (10) is 20-80 µm.

9. Method according to one of the preceding claims,
**characterized in that** the thickness of the covering layer (11) is 40-200 µm.

10. Method according to one of the preceding claims,
**characterized in that**
the cavity (2) milled into the card body (1) for accommodating the chip module (3) is of a two-step design having an indentation (20) located in the middle of the cavity (2) and a supporting shoulder (21) surrounding said indentation (20), with the exposed coil terminals (10A1, 10A1*) being arranged on the supporting shoulders (21),
and
a chip module (3) is used which is composed of a first part in the form of a molded housing (3A) having the integrated circuit (31) and the connecting wires (33) from the integrated circuit (31) to the metallic contacts (32, 32*) for connection to the coil terminals (10A1, 10A1*), and of a second part (3B) which projects over the edge of the molded housing (3A) and which has metallic contacts (32, 32*) for connection to the coil terminals (10A1, 10A1*), wherein the chip module (3) is connected in a prone position, at least by its second part (3B) projecting beyond the molded housing (3A), to the card body (1) on the milled-out supporting shoulder (21), and an electroconductive connection is produced between the contacts (32, 32*) of the chip module (3) and the coil terminals (10A1, 10A1*).

11. Method according to one of the preceding claims,
**characterized in that** the contacts (32, 32*) of the chip module (3) are connected to the coil terminals (10A1, 10A1*) by means of an electroconductive adhesive (5).

12. Method according to one of the preceding claims,
**characterized in that**
the chip module (3) is mechanically fixed in the card body (1) by means of the electroconductive adhesive (5).

13. Method according to Claim 11,
**characterized in that**, in addition to the electroconductive adhesive (5), the chip module (3) is mechanically fixed in the card body (1) by means of an adhesive connection (6).

14. Method according to one of Claims 1 to 10,
**characterized in that**
the contacts (32, 32*) of the chip module (3) are electroconductively connected to the coil terminals (10A1, 10A1*) using a soldering process.

15. Method according to Claim 14,
**characterized in that**
the chip module (3) is simultaneously fixed mechanically in the card body by means of the soldered connection.

16. Method according to Claim 14,
**characterized in that**
in addition to the soldered connection, the chip module (3) is mechanically fixed in the card body (1) by means of an adhesive connection.

17. Method according to one of the preceding claims,
**characterized in that**
a chip module (3) is used which, in addition to the contacts (32, 32*) for the electroconductive connection to the coil terminals (10A1, 10A1*), has contact areas (34) which are arranged on the side of the chip module (3) lying opposite the contacts (32, 32*) and which serve for contact-type power supply and/or data exchange with external devices.

## Revendications

1. Procédé pour la fabrication d'une carte à puce comprenant
- un corps de carte (1) en matière synthétique à plusieurs couches,
- un circuit de commutation (31) intégré dans un module à puce (3),
- au moins une bobine (10A) qui sert à l'alimentation en énergie et / ou à l'échange de données entre le circuit de commutation intégré et des appareils externes, le module à puce (3) présentant au moins deux contacts métalliques (32, 32*) pour la connexion électrique, conductrice du circuit de commutation intégré (31) avec les raccords de la bobine (10A) disposée sur une couche de support de bobine (10),
le procédé comprenant les étapes de
- préparation de la couche de support de bobine (10), avec la bobine (10A), agencée sur celle-ci, et les raccords de bobine (10A1, 10A1*),
- préparation d'autres couches (14, 15),
- superposition exacte de ces couches (10, 14, 15),
- introduction des couches de carte superposées dans une presse à laminer (4) où les couches de la carte sont reliées entre elles sous pression et chaleur,
- extraction des couches de carte laminées de la presse à laminer (4),
- fraisage d'un évidement (2) pour la réception du module à puce (3) dans le corps de carte laminé (1), les raccords (10A1, 10A1*) de la bobine étant dénudés, et
- insertion du module à puce (3) dans l'évidement (2) du corps de carte (1), et réalisation de la liaison conductrice en électricité entre les contacts (32, 32*) du module à puce (3) et les raccords (10A1, 10A1*) de la bobine,
**caractérisé en ce que**,
a) en supplément, sont préparées une couche de recouvrement (11), à appliquer sur la couche de support (10) portant la bobine, et, en plus, une couche de compensation d'épaisseur (12) à appliquer sur la couche de recouvrement (11), la couche de recouvrement (11) présentant des évidements (11A1, 11A1*) correspondant aux raccords de bobine (10A1, 10A1*),
b) lors de la superposition en position exacte de ces couches de carte (10, 11, 12, 14, 15) les unes au-dessus des autres, la couche de recouvrement (11) est positionnée de sorte que les évidements (11A, 11A*) dans la couche de recouvrement (11), se trouvent chacun dans le secteur des raccords de bobine (10A1, 10A1*),
c) pendant le processus de laminage, dans la presse à laminer (4), où les couches de la carte sont reliées entre elles sous pression et chaleur, une masse synthétique est pressée, de la couche de support de bobine (10), en soulevant les raccords de bobine (10A1, 10A1*), dans les évidements (11A, 11A*) de la couche de recouvrement (11),
d) lors du fraisage des évidements (2), pour le logement du module à puce (3) dans le corps de carte laminé (1), les raccords de bobine (10A1, 10A1*) soulevés sont libérés.

2. Procédé selon la revendication 1,
**caractérisé en ce que**,
en plus des couches mentionnées, est préparée une autre couche de compensation d'épaisseur (13) à appliquer sur le côté de la couche de support de bobine opposé aux raccords de bobine.

3. Procédé selon la revendication 2,
**caractérisé en ce que**
la couche de compensation d'épaisseur (12), qui est disposée sur la couche de recouvrement (11), et la couche de compensation d'épaisseur (13), qui est disposée sur la couche de support de bobine (10), sont imprimées, et que, sur chacune des couches de compensation d'épaisseur (12,13) imprimées, est agencée une autre couche de compensation d'épaisseur (14,15) transparente, en tant que couche de recouvrement de la carte.

4. Procédé selon l'une des revendications précédentes,
**caractérisé en ce que**
la matière synthétique de la couche de support de bobine (10) présente une plus faible résistance à la déformation sous l'influence de la pression et de la chaleur que les matières synthétiques de la couche de recouvrement (11) et de la couche de compensation d'épaisseur (12) disposées au-dessus de celle-ci.

5. Procédé selon la revendication 4,
**caractérisé en ce que**
la couche de support de bobine (10), la couche de recouvrement (11) ainsi que la couche de compensation d'épaisseur (12) consistent en la même matière synthétique, la matière synthétique contenant des particules de charges, comme par exemple du dioxyde de titane, qui accroissent la stabilité de forme, et que la concentration des charges de la couche de support de bobine (10) et, ainsi, la stabilité de forme de cette couche (11) sont plus faibles que celle des autres couches (11,12).

6. Procédé selon la revendication 5,
**caractérisé en ce que**
la matière synthétique est du polyester non recristallisant thermiquement, comme, par exemple, du polytéréphtalate d'éthylène, abrévié par PETG.

7. Procédé selon la revendication 4,
**caractérisé en ce que**
la couche de support de bobine (10) consiste en PVC et la couche de recouvrement (11) et la couche de compensation d'épaisseur (12) en polycarbonate.

8. Procédé selon l'une des revendications précédentes,
**caractérisé en ce que**
l'épaisseur des raccords de bobine (10A1, 10A1*) sur la couche de support de bobine (10) est de 20-80 µm.

9. Procédé selon l'une des revendications précédentes,
**caractérisé en ce que**
l'épaisseur de la couche de recouvrement (11) est de 40-200 µm.

10. Procédé selon l'une des revendications précédentes,
**caractérisé en ce que**
l'évidement (2), fraisé dans le corps de carte (1) pour le logement du module à puces (3) est formé à deux gradins, avec une cavité (20) située au centre de l'évidement (2) et un épaulement de support (21) qui entoure cette cavité (20), les raccords de bobine dégagés (10A1, 10A1*) étant disposés sur les épaulements de support (21),
et
un module à puce (3) étant utilisé, lequel est composé d'une première partie en forme de boîtier moulé (3A) qui présente le circuit de commutation intégré (31) et les lignes de raccordement (33) du circuit de commutation intégré (31) à destination des contacts métalliques (32,32*) pour la liaison avec les raccords (10A1,10A1*) de la bobine, et d'une deuxième partie (38) qui fait saillie au-delà du bord du boîtier moulé (3A) et est équipée des contacts métalliques (32,32*) pour la liaison avec les raccords (10A1,10A1*) de la bobine, le module à puce (3) étant relié au corps de carte (1) au moins par sa deuxième partie (3B) reposant sur l'épaulement (21) fraisé, en faisant saillie au-delà du boîtier moulé (3A), et une liaison électro-conductrice étant réalisée entre les contacts (32,32*) du module à puces (3) et les raccords de bobine (10A1,10A1*).

11. Procédé selon l'une des revendications précédentes,
**caractérisé en ce que**
les contacts (32,32*) du module à puce (3) sont reliés aux raccords de bobine (10A1, 10A1*) par l'intermédiaire d'une colle (5) électro-conductrice.

12. Procédé selon l'une des revendications précédentes,
**caractérisé en ce que**
le module à puce (3) est mécaniquement fixé dans le corps de carte (1) au moyen de la colle électro-conductrice (5).

13. Procédé selon la revendication 11,
**caractérisé en ce que**
le module à puce (3) est mécaniquement fixé dans le corps de carte (1) par assemblage collé (6) en plus de la liaison au moyen de la colle conductrice (5).

14. Procédé selon l'une des revendications 1 à 10,
**caractérisé en ce que**
les contacts (32,32*) du module à puce (3) est en mise en liaison électro-conductrice avec les raccords de bobine (10A1, 10A1*) par un processus de soudure.

15. Procédé selon la revendication 14,
**caractérisé en ce que**
le module à puce (3) est simultanément fixé mécaniquement dans le corps de la carte au moyen de la liaison par soudure.

16. Procédé selon la revendication 14,
**caractérisé en ce que**
le module à puce (3) est mécaniquement fixé dans le corps de carte (1) au moyen d'un assemblage collé, en plus de la liaison par soudure.

17. Procédé selon l'une des revendications précédentes,
**caractérisé en ce que**
l'on utilise un module à puce (3) qui, à côté des contacts (32,32*), présente, pour la liaison électro-conductrice avec les raccords de bobine (10A1, 10A1*), des surfaces de contact (34) qui sont disposées sur la surface du module à puce (3) située à l'opposée des contacts (32,32*), et servent à l'alimentation en énergie et / ou à l'échange de données avec des appareils externes.
